(19) Europäisches Patentamt
European Patent Office
Office européen des brevets

(11) **EP 2 097 977 B1**

(12) **FASCICULE DE BREVET EUROPEEN**

(45) Date de publication et mention
de la délivrance du brevet:
**10.08.2011 Bulletin 2011/32**

(21) Numéro de dépôt: **07857345.8**

(22) Date de dépôt: **10.12.2007**

(51) Int Cl.:
**H03J 3/08** (2006.01)

(86) Numéro de dépôt international:
**PCT/EP2007/063625**

(87) Numéro de publication internationale:
**WO 2008/071668 (19.06.2008 Gazette 2008/25)**

(54) **PROCEDE ET DISPOSITIF PERMETTANT D'OPTIMISER LE TEMPS D'ACCORD D'UN FILTRE ACCORDABLE**

VERFAHREN UND EINRICHTUNG ZUM OPTIMIEREN DER EINSTELLZEIT EINES EINSTELLBAREN FILTERS

METHOD AND DEVICE FOR OPTIMISING THE ADJUSTMENT TIME OF AN ADJUSTABLE FILTER

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **12.12.2006 FR 0610810**

(43) Date de publication de la demande:
**09.09.2009 Bulletin 2009/37**

(73) Titulaire: **Thales**
**92200 Neuilly Sur Seine (FR)**

(72) Inventeur: **JAHIER, Vincent**
**95320 St Leu La Foret (FR)**

(74) Mandataire: **Dudouit, Isabelle**
**Marks & Clerk France**
**Conseils en Propriété Industrielle**
**Immeuble " Visium "**
**22, avenue Aristide Briand**
**94117 Arcueil Cedex (FR)**

(56) Documents cités:
WO-A-03/038996      GB-A- 1 181 386
GB-A- 2 100 932       US-A- 3 541 451
US-A- 4 612 571        US-A1- 2004 127 178

**Description**

L'invention concerne un procédé et un dispositif permettant d'optimiser le temps d'accord d'un filtre tractable, filtre dont la réponse en fréquence varie en fonction de la tension de commande du filtre.

Les systèmes de radiocommunications comportent généralement un module amplificateur, connecté entre, d'une part, un module radiofréquences, et d'autre part, un système antennaire. La fonction d'un tel module est d'amplifier le signal utile en émission comme en réception. Plus particulièrement, le signal utile amplifié transmis via le système antennaire doit être suffisamment puissant pour atteindre la portée voulue, occuper une bande de fréquence correspondant à la forme d'onde employée pour atteindre les performances notamment en débit souhaité, tout en respectant les contraintes normatives et réglementaires imposées.

Généralement, les systèmes sont placés dans des environnements où il existe des brouilleurs proches dont le niveau peut être élevé et engendrent des phénomènes néfastes au fonctionnement du dispositif.

Un tel filtre est divulgué dans la publication de brevet US 3541451.

Pour atteindre les performances requises, il est en général implanté en entrée radio fréquence du poste, un filtre à poids de capacité désigné sous la dénomination « filtre tractable » qui doit répondre rapidement en fonction de sa tension de commande.

La rapidité de réponse en fréquence du filtre doit être inférieure ou égale au temps d'accord en fréquence du poste afin de ne pas dégrader les caractéristiques de rapidité du poste.

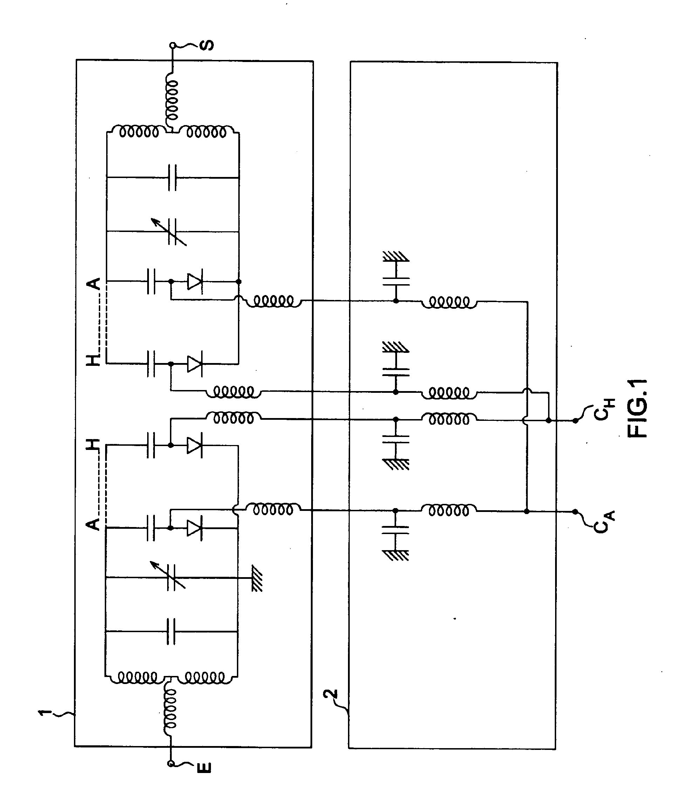

La figure 1 montre, par un synoptique, un filtre à poids de capacité selon l'état de la technique. Le filtre comprend une carte principale 1. La carte principale 1 comporte une entrée E par laquelle un signal à filtrer est reçu, et une sortie S sur laquelle un signal filtré est délivré. La carte principale 1 comprend deux circuits résonants couplés magnétiquement. La carte principale 1 comporte encore des poids de capacité (sur la figure 1, 8 poids de capacité pour chaque circuit résonant désignés par les lettres A à H). Le nombre de poids de capacité est lié à l'étendue de la bande de fréquence couverte par filtre ainsi que la bande de fréquence intrinsèque dudit filtre. Chaque poids de capacité A..H comporte sur la figure 1 une capacité et une diode. Chaque poids de capacité est commandé par des signaux reçus d'une carte de gestion et de contrôle 2. La carte de gestion et de contrôle 2 transforme les commandes qu'elle reçoit sur des entrées $C_A...C_H$ en commandes pour les poids de capacités A..H. La carte de gestion et de contrôle 2 et la carte principale 1 sont généralement réalisé sur deux cartes électroniques distinctes interconnectées.

L'invention concerne un dispositif associé à la commande d'un filtre tractable caractérisé en ce qu'il comporte en combinaison au moins les éléments suivants :

○ une self de valeur de résistance série Rs et d'inductance série Ls obtenue de la manière suivante :

Une inductance étant représentée par une inductance $L_p$, une résistance $R_p$, ou une capacité $C_p$ avec les relations :

$$R_p = Q.L.\omega_0 \, , \ C_p = \frac{1}{L.\omega_0^2} \, , \ L_p = L \qquad (1)$$

avec
Q, le coefficient de surtension de l'inductance,
L, la valeur de l'inductance, valeur choisie initialement en fonction de la fréquence de travail et de l'application,
$\omega_0$, la pulsation de travail.

$$Y_{self} = \frac{1}{R_p} + j(C_p\omega_0 - \frac{1}{L_p\omega_0}) \qquad (2)$$

admittance équivalente de la self,
En posant $Y_{Self} = \alpha - j\beta$

$$Z_{self} = \frac{1}{Y_{self}} = (\frac{\alpha}{\alpha^2 + \beta^2}) + j(\frac{\beta}{\alpha^2 + \beta^2}) \qquad (3)$$

impédance équivalente de la self,

On déduit la valeur de $R_s = \dfrac{\alpha}{\alpha^2 + \beta^2}$ et $L_s = 1/\omega_0 \left[ \dfrac{\beta}{\alpha^2 + \beta^2} \right]$

○ une résistance série $r_{série}$ dont la valeur est déterminée à partir de l'expression:

$$\frac{0.99.\boldsymbol{R}_p \pm \sqrt{(0.99\boldsymbol{R}_p)^2 - 4.\boldsymbol{I}_0{}^2 \omega_0{}^2}}{2}$$

où Rp correspondant à la résistance parallèle de la self, $L_o$ l'inductance à la fréquence de résonance, $\omega_0$ la fréquence de résonance, et en prenant la valeur de résistance la moins élevée et en déduisant $r_{série}$ à partir de R = $r_{série}$ + Rs.

L'invention offre notamment les avantages suivants :

- Il permet d'atteindre des temps d'accord rapides du filtre auquel il est associé, en limitant les résonances de la self dans sa réponse en fréquence ;
- Il permet d'isoler la partie RF de la partie continue plus connue sous l'expression « choker » la tension de commande.

D'autres caractéristiques et avantages de la présente invention apparaîtront mieux à la lecture de la description qui suit d'un exemple de réalisation donné à titre illustratif et nullement limitatif annexé des figures qui représentent :

- La figure 1 le synoptique d'un filtre tractable,
- La figure 2 une représentation d'une inductance,
- La figure 3 un schéma des différents éléments constituant le dispositif d'accord associé à la commande du filtre tractable.

Le dispositif selon l'invention est disposé au niveau de la commande du filtre tractable et pour un dispositif réalisé sur un circuit imprimé CMS. Le dispositif comprend un ensemble composé d'une self et d'une résistance série, dont les valeurs R et L sont déterminées de la manière décrite ci-après.

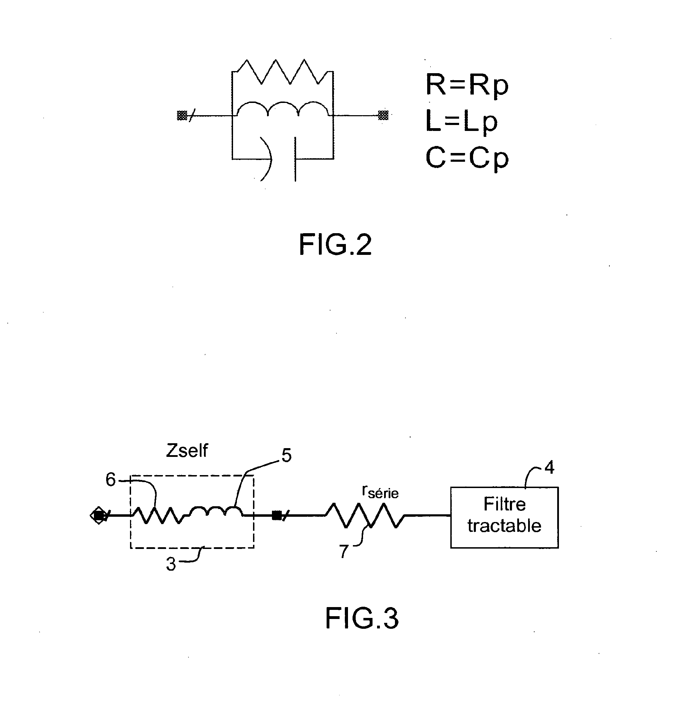

Une inductance CMS peut-être représentée par $L_p$, $R_p$, $C_p$ (figure 2, les indices p désignant un schéma en parallèle) avec les relations :

$$R_p = Q.L.\omega_0 \; , \; C_p = \frac{1}{L.\omega_0{}^2} \; , \; L_p = L \qquad (1)$$

avec
Q, le coefficient de surtension de l'inductance,
L, la valeur de l'inductance, valeur choisie initialement en fonction de la fréquence de travail et de l'application,
$\omega_0$, la pulsation de travail.

$$Y_{self} = \frac{1}{R_p} + j\left(C_p\omega_0 - \frac{1}{L_p\omega_0}\right) \qquad (2)$$

admittance équivalente de la self,

En posant $Y_{self} = \alpha - j\beta$

$$Z_{self} = \frac{1}{Y_{self}} = (\frac{\alpha}{\alpha^2 + \beta^2}) + j(\frac{\beta}{\alpha^2 + \beta^2}) \quad (3)$$

impédance équivalente de la self,

Si $R_s = \dfrac{\alpha}{\alpha^2 + \beta^2}$ et $.L_s.\omega_0 = \dfrac{\beta}{\alpha^2 + \beta^2}$ , alors

$$Z_{self} = R_s + j.L_s.\omega_0 \qquad (4)$$

le procédé consiste donc à insérer en série avec l'inductance CMS une résistance série ($r_{série}$).

La figure 3 schématise un exemple d'un dispositif 3 selon l'invention associé à la commande d'un filtre tractable 4. Le dispositif 3 comprend une self Zself ayant une inductance Ls, 5, et une résistance Rs, 6, en série avec une résistance $r_{série}$, 7.

Le schéma équivalent est :

$$Z_{équivalent} = Z_{self} + r_{série} = r_{série} + R_s + j.L_s.\omega_0 \quad (5)$$

En posant R= $r_{série}$ + $R_s$,

$$Z_{équivalent} = R + jl_0\omega_0$$

$$Y_{équivalent} = \frac{1}{Z_{équivalent}} = (\frac{R}{R^2 + l_0^2\omega_0^2}) - j(\frac{l_0\omega_0}{R^2 + l_0^2\omega_0^2}) \qquad (6)$$

En considérant qu'en vérifiant $\dfrac{R^2 + l_0^2\omega_0^2}{R} = 99\%.R_p$ , les caractéristiques de X l'inductance CMS sont peu dégradées par l'ajout de la résistance série. Il est possible d'obtenir les deux valeurs R1 et R2 définies par

$$R_{1,2} = \frac{0.99.R_p \pm \sqrt{(0.99R_p)^2 - 4.l_0^2\omega_0^2}}{2}$$

Le procédé selon l'invention consiste alors à sélectionner la valeur de résistance la moins élevée et à partir de la relation R = $r_{série}$ + Rs, d'en déduire $r_{série}$.

L'étape suivante consiste à sélectionner la valeur de résistance normalisée, par exemple, la plus proche.

Tout type de résistance composant de montage en surface ou CMS, ou toute autre peut être utilisé pour mettre en oeuvre la présente invention.

De même, tout type d'inductance CMS ou autre peut être utilisé dans la présente invention.

**Revendications**

1. Dispositif associé à la commande d'un filtre tractable comportant en combinaison au moins les éléments suivants :

○ une self de valeur de résistance série Rs et d'inductance série Ls dont les valeurs respectives sont obtenues de la manière suivante :

Une inductance étant représentée par une inductance $L_p$, une résistance $R_p$, ou une capacité $C_p$ avec les relations :

$$R_p = Q.L.\omega_0 \ , \ C_p = \frac{1}{L.\omega_0{}^2} \ , \ L_p = L \qquad (1)$$

avec
Q, le coefficient de surtension de l'inductance,
L, la valeur de l'inductance, valeur choisie initialement en fonction de la fréquence de travail et de l'application,
$\omega_0$, la pulsation de travail,

$$Y_{self} = \frac{1}{R_p} + j(C_p\omega_0 - \frac{1}{L_p\omega_0}) \qquad (2)$$

admittance équivalente de la self,
En posant $Y_{self} = \alpha - j\beta$

$$Z_{self} = \frac{1}{Y_{self}} = (\frac{\alpha}{\alpha^2 + \beta^2}) + j(\frac{\beta}{\alpha^2 + \beta^2}) \ (3)$$

impédance équivalente de la self,

la valeur de $R_9$ est égale à $\frac{\alpha}{\alpha^2 + \beta^2}$ et la valeur de $L_s$ est égale à $1/\omega_0[\frac{\beta}{\alpha^2 + \beta^2}]$

○ **caractérisé en ce qu'**il comporte en outre une résistance série $r_{série}$ disposée en série avec l'inductance et dont
la valeur est déterminée à partir de l'expression :

$$\frac{0.99.R_p \pm \sqrt{(0.99R_p)^2 - 4\ L_0{}^2\omega_0{}^2}}{2}$$

où $Rp$ correspondant à la résistance parallèle de la self, $L_0$ l'inductance à la fréquence de résonance, $\omega_0$ la fréquence de résonance, et en prenant la valeur de résistance la moins élevée et en déduisant $r_{série}$ à partir de $R = r_{série} + Rs$.

2. Dispositif selon la revendication 1, **caractérisé en ce que** la résistance série est une résistance réalisée en composant de montage en surface ou CMS.

3. Dispositif selon la revendication 1, **caractérisé en ce que** l'inductance est une inductance CMS.

4. Procédé pour déterminer un dispositif associé à un filtre tractable comportant au moins les étapes suivantes :

○ choisir une self de valeur de résistance série Rs et d'inductance série
Ls obtenue de la manière suivante :
Une inductance étant représentée par une inductance $L_p$, une résistance $R_p$, ou une capacité $C_p$ avec les relations :

$$R_p = Q.L.\omega_0 \,, \; C_p = \frac{1}{L.\omega_0^2} \,, \; L_p = L \qquad (1)$$

avec
Q, le coefficient de surtension de l'inductance,
L, la valeur de l'inductance, valeur choisie initialement en fonction de la fréquence de travail et de l'application,
$\omega_0$, la pulsation de travail,

$$Y_{self} = \frac{1}{R_p} + j(C_p\omega_0 - \frac{1}{L_p\omega_0}) \quad (2)$$

admittance équivalente de la self,
En posant Yself$=\alpha\text{-}j\beta$

$$Z_{self} = \frac{1}{Y_{self}} = (\frac{\alpha}{\alpha^2 + \beta^2}) + j(\frac{\beta}{\alpha^2 + \beta^2}) \; (3)$$

impédance équivalente de la self, On déduit la valeur de $R_s = \dfrac{\alpha}{\alpha^2 + \beta^2}$ et $L_s = 1/\omega_0 [\dfrac{\beta}{\alpha^2 + \beta^2}]$ ca-

**ractérisé en ce qu'**il comporte en outre
o Déterminer la valeur pour une resistance série $r_{série}$ déterminée à partir de l'expression:

$$\frac{0.99.R_p \pm \sqrt{(0.99R_p)^2 - 4 L_0^2\omega_0^2}}{2}$$

où Rp correspondant à la résistance parallèle de la self, $L_o$, l'inductance à la fréquence de résonance, $a_b$ la fréquence de résonance, choisir la valeur de résistance la moins élevée et en déduisant $r_{série}$ à partir de R = $s_{érie}$ + Rs.

5. Procédé selon la revendication 4, **caractérisé en ce que** l'on utilise des composants de montage en surface ou CMS.

## Claims

1. A device associated with the control of a tractable filter, comprising the combination of at least the following elements:

   o an induction coil having a series resistor Rs value and a series inductor Ls value, which values are obtained as follows:

   an inductor being represented by an inductance $L_p$, a resistance $R_p$, or a capacitance $C_p$ with the following relations:

$$R_p = Q.L.\omega_0, \quad C_p = \frac{1}{L.\omega_0^2}, \quad L_p = L \qquad (1)$$

where
Q is the overvoltage coefficient of the inductor,
L is the value of the inductor, which value is initially selected as a function of the working frequency and of the application,
$\omega_0$ is the working pulse,

$$Y_{self} = \frac{1}{R_p} + j(C_p\omega_0 - \frac{1}{L_p\omega_0})$$

(2) is an equivalent admittance of the induction coil,
by establishing $Y_{self} = \alpha - j\beta$

$$Z_{self} = \frac{1}{Y_{self}} = (\frac{\alpha}{\alpha^2 + \beta^2}) + j(\frac{\beta}{\alpha^2 + \beta^2})$$ (3) is an equivalent impedance of the induction coil,

the value of $R_3$ is equal to $\frac{\alpha}{\alpha^2 + \beta^2}$ and the value of $L_6$ is equal to $1/\omega_0[\frac{\beta}{\alpha^2 + \beta^2}]$ **characterised in that** it further comprises:

o a series resistor $r_{série}$ arranged in series with the induction coil and the value of which is determined from the following expression:

$$\frac{0.99.R_p \pm \sqrt{(0.99R_p)^2 - 4.l_0^2\omega_0^2}}{2}$$

with Rp corresponding to the parallel resistance of the induction coil, $L_0$ to the inductance at the resonance frequency, $\omega_0$ to the resonance frequency, and by selecting the lowest resistance value and calculating $r_{série}$ from R = $r_{série}$ + Rs.

2. The device according to claim 1, **characterised in that** the series resistor is a resistor produced as a surface mounted or CMS component.

3. The device according to claim 1, **characterised in that** the inductor is a CMS ) inductor.

4. A process for determining a device associated with a tractable filter comprising at least the following steps:

o selecting an induction coil having a series resistor Rs value and a series inductor Ls value obtained as follows:

an inductor being represented by an inductance $L_p$, a resistance $R_p$, or a capacitance $C_p$ with the following relations:

$$R_p = Q.L.\omega_0, \quad C_p = \frac{1}{L.\omega_0^2}, \quad L_p = L \qquad (1)$$

where
Q is the overvoltage coefficient of the inductor,
L is the value of the inductor, which value is initially selected as a function of the working frequency and of the application,

$\omega_0$ is the working pulse,

$$Y_{self} = \frac{1}{R_p} + j(C_p\omega_0 - \frac{1}{L_p\omega_0})$$

(2) is an equivalent admittance of the induction coil, by establishing $Y_{self} = \alpha - j\beta$

$$Z_{self} = \frac{1}{Y_{self}} = (\frac{\alpha}{\alpha^2 + \beta^2}) + j(\frac{\beta}{\alpha^2 + \beta^2})$$

(3) is an equivalent impedance of the induction coil,

it is possible to calculate the value of $R_s = \frac{\alpha}{\alpha^2 + \beta^2}$ and $L_s = 1/\omega_0[\frac{\beta}{\alpha^2 + \beta^2}]$ **characterised in that**

it further comprises:

o determining the value for a determined series resistor $r_{série}$ from the following expression:

$$\frac{0.99.R_p \pm \sqrt{(0.99R_p)^2 - 4.l_0{}^2\omega_0{}^2}}{2}$$

with Rp corresponding to the parallel resistance of the inductor, $L_0$ to the inductance at the resonance frequency, $\omega_0$ to the resonance frequency, and by selecting the lowest resistance value and calculating $r_{série}$ from $R = r_{série} + Rs$.

5. The process according to claim 4, **characterised in that** surface mounted or CMS components are used.

**Patentansprüche**

1. Vorrichtung in Verbindung mit der Steuerung eines regulierbaren Filters, die in Kombination wenigstens die folgenden Elemente umfasst:

o eine Induktionsspule mit einem Wert eines Serienwiderstands Rs und eines Serieninduktors Ls, wobei diese Werte wie folgt erhalten werden:

wobei ein Induktor durch eine Induktanz $L_p$, einen Widerstand $R_p$ oder eine Kapazität $C_p$ mit den folgenden Beziehungen repräsentiert wird:

$$R_p = Q.L.\omega_0 , \quad C_p = \frac{1}{L.\omega_0{}^2} , \quad L_p = L \qquad (1)$$

wobei
Q der Überspannungskoeffizient des Induktors ist,
L der Induktanzwert ist, der zunächst in Abhängigkeit von der Arbeitsfrequenz und der Anwendung gewählt wird,
$\omega_0$ der Arbeitsimpuls ist,

$$Y_{self} = \frac{1}{R_p} + j(C_p\omega_0 - \frac{1}{L_p\omega_0}) \qquad (2)$$

(2) ein äquivalenter Scheinleitwert der Induktionsspule ist,
durch Festlegen von $Y_{self} = \alpha - j\beta$

$$Z_{self} = \frac{1}{Y_{self}} = (\frac{\alpha}{\alpha^2 + \beta^2}) + j(\frac{\beta}{\alpha^2 + \beta^2}) \qquad (3)$$

(3) eine äquivalente Impedanz der Induktionsspule ist,

der Wert von $R_3$ gleich $\frac{\alpha}{\alpha^2 + \beta^2}$ und der Wert von $L_6$ gleich $1/\omega_0[\frac{\beta}{\alpha^2 + \beta^2}]$ ist, **dadurch gekennzeichnet,**

**dass** sie ferner Folgendes umfasst:

o einen Serienwiderstand $r_{série}$, der in Serie mit dem Induktor geschaltet ist und dessen Wert anhand des folgenden Ausdrucks ermittelt wird:

$$\frac{0.99.R_p \pm \sqrt{(0.99 R_p)^2 - 4.l_0^2\omega_0^2}}{2}$$

wobei Rp dem Parallelwiderstand des Induktors entspricht, $L_o$ der Induktanz bei der Resonanzfrequenz, $\omega_o$ der Resonanzfrequenz, und durch Wählen des niedrigsten Widerstandswertes und durch Ableiten von $r_{série}$ von R $= r_{série}$ + Rs.

2. Vorrichtung nach Anspruch 1, **dadurch gekennzeichnet, dass** der Serienwiderstand ein Widerstand ist, der als oberflächenmontierte oder CMS-Komponente realisiert wird.

3. Vorrichtung nach Anspruch 1, **dadurch gekennzeichnet, dass** der Induktor ein CMS-Induktor ist.

4. Verfahren zum Ermitteln einer Vorrichtung in Verbindung mit einem regulierbaren Filter, das wenigstens die folgenden Schritte beinhaltet:

o Wählen einer Induktionsspule mit einem Wert des Serienwiderstands Rs und der Serieninduktanz Ls, der wie folgt erhalten wird:

wobei ein Induktor repräsentiert wird durch eine Induktanz $L_p$, einen Widerstand $R_p$ oder eine Kapazität $C_p$ mit den folgenden Beziehungen:

$$R_p = Q.L.\omega_0 , \quad C_p = \frac{1}{L.\omega_0^2} , \quad L_p = L \qquad (1)$$

wobei
Q der Überspannungskoeffizient des Induktors ist,
L der Induktanzwert ist, der zunächst in Abhängigkeit von der Arbeitsfrequenz und der Anwendung gewählt wird,
$\omega_o$ der Arbeitsimpuls ist,

$$Y_{self} = \frac{1}{R_p} + j(C_p\omega_0 - \frac{1}{L_p\omega_0})$$

(2) ein äquivalenter Scheinleitwert der Induktionsspule ist, durch Festlegen von $Y_{self} = \alpha - j\beta$

$$Z_{self} = \frac{1}{Y_{self}} = (\frac{\alpha}{\alpha^2 + \beta^2}) + j(\frac{\beta}{\alpha^2 + \beta^2})$$

(3) eine äquivalente Impedanz der Induktionsspule ist,

durch Ableiten des Wert von $R_s = \frac{\alpha}{\alpha^2 + \beta^2}$ und $L_s = 1/\omega_0 [\frac{\beta}{\alpha^2 + \beta^2}]$, **dadurch gekennzeichnet, dass**

es ferner Folgendes beinhaltet:
o Ermitteln des Wertes für einen bestimmten Serienwiderstand $r_{série}$, anhand folgenden Ausdrucks:

$$\frac{0.99.R_p \pm \sqrt{(0.99R_p)^2 - 4.l_0{}^2\omega_0{}^2}}{2}$$

wobei Rp dem Parallelwiderstand der Induktionsspule entspricht, $L_o$ der Induktanz auf der Resonanzfrequenz, $\omega_o$ der Resonanzfrequenz, und Wählen des niedrigsten Widerstandswertes und Ableiten von $r_{série}$ von R = $r_{série}$ + Rs.

5. Verfahren nach Anspruch 4, **dadurch gekennzeichnet, dass** oberflächenmontierte oder CMS-Komponenten verwendet werden.

FIG.1

$$R=Rp$$
$$L=Lp$$
$$C=Cp$$

## FIG.2

Zself

6

5

3

$r_{série}$

7

Filtre
tractable

4

## FIG.3

**EP 2 097 977 B1**

## RÉFÉRENCES CITÉES DANS LA DESCRIPTION

**Documents brevets cités dans la description**

*   US 3541451 A